# EUROPÄISCHE PATENTANMELDUNG

(11) **EP 3 388 217 A1**
(43) Veröffentlichungstag der Anmeldung: **17.10.2018**
(21) Anmeldenummer: 17166126.7
(22) Anmeldetag: 11.04.2017
(51) Int. Cl.: B29C 45/00, B81C 1/00

(54) **HALBZEUG UND VERFAHREN ZUR HERSTELLUNG EINES MINDESTENS EIN MIKROBAUTEIL AUFWEISENDEN HALBZEUGS**

(71) Anmelder: BETA Beratungs- und Beteiligungs-GmbH, 4040 Linz (AT)
(72) Erfinder: Kreuzmayr, Dominik, 4701 Bad Schallerbach (AT)
(74) Vertreter: Jell, Friedrich

(57) **Zusammenfassung**

Es wird ein Halbzeug (1) und ein Verfahren zur Herstellung eines mindestens ein Mikrobauteil (3) aufweisenden Halbzeugs (1) unter Verwendung eines Mehrkomponenten-Spritzgießverfahrens gezeigt, bei dem wenigstens ein Formraum eines Spritzgießwerkzeugs mit mindestens einem verlorenen Teil (2) aus einem ersten Werkstoff, insbesondere aus einem spritzgegossenen Kunststoffmaterial, versehen wird und in einem weiteren Schritt zur Erzeugung des Mikrobauteils (3) ein zum ersten Werkstoff unterschiedlicher zweiter Werkstoff auf einer Elastomerbasis, insbesondere Silikonbasis, eingespritzt wird, wodurch sich zwischen Mikrobauteil (3) und verlorenem Teil (2) eine feste und formschlüssige Verbindung (4) ausbildet. Um risikofrei vorteilhafte Zykluszeiten erreichen zu können, wird vorgeschlagen, dass das verlorene Teil (2) als makroskopischer Objektträger (5) für das Mikrobauteil (3) zur Handhabung des Halbzeugs (1) ausgebildet wird und der Formraum mit diesem verlorenen Teil (2) versehen wird.

## Beschreibung

Die Erfindung betrifft ein Halbzeug und ein Verfahren zur Herstellung eines mindestens ein Mikrobauteil aufweisenden Halbzeugs unter Verwendung eines Mehrkomponenten-Spritzgießverfahrens, bei dem wenigstens ein Formraum eines Spritzgießwerkzeugs mit mindestens einem verlorenen Teil aus einem ersten Werkstoff, insbesondere aus einem spritzgegossenen Kunststoffmaterial, versehen wird und in einem weiteren Schritt zur Erzeugung des Mikrobauteils ein zum ersten Werkstoff unterschiedlicher zweiter Werkstoff auf einer Elastomerbasis, insbesondere Silikonbasis, eingespritzt wird, wodurch sich zwischen Mikrobauteil und verlorenem Teil eine feste und formschlüssige Verbindung ausbildet.

Zur Erzeugung von mehrkomponentigen Makrobauteilen, bestehend aus zwei unterschiedlichen Kunststoffen, ist es bekannt (DE102011102571A1), ein Zweikomponenten-Spritzgießverfahren zu verwenden. Hiebei wird ein in einer Kavität eines Spritzgießwerkzeugs eingesetztes Teil mit einem anderen Werkstoff teilweise umspritzt. Dabei geht der andere Werkstoff mit dem eingesetzten Teil eine feste stoffschlüssige Verbindung ein, was zu einem Halbzeug führt, von dem über Sollbruchstellen fertige mehrkomponentige Makrobauteile abgebrochen werden können. Der umspritzte Teil dienst sowohl als Teil der mehrkomponentigen Makrobauteile als auch als Objektträger für die Makrobauteile.

Aus dem technischen Gebiet des Mikrospritzgusses, welcher zur Erzeugung von Kleinstbauteilen im Gewichtsbereich unterhalb von einem Milligramm verwendet wird, ist es bekannt (DE19850046A1), Hohlstrukturen mithilfe eines Lösekerns bzw. verlorener Kern bzw. verlorenen Teils zu realisieren. Hierzu wird unter Verwendung eines Zweikomponenten-Spritzgießverfahrens der verlorene Teil umspritzt, wodurch sich zwischen diesen eine unlösbare, feste und formschlüssige Verbindung ausbildet. Anschließend wird der verlorene Teil aufgelöst, um diesen vom Halbzeug zu entfernen und so zum Mikrobauteil zu gelangen. Verschiedenste Werkstoffe für das Mikrobauteil und für den verlorenen Teil sind im Stand der Technik bekannt. Trotz der spritzgusstechnischen Schwierigkeiten in diesem technischen Gebiet des Mehrkomponenten-Mikrospritzgusses stellt zunehmend die Handhabung der damit erzeugten Mikrobauteile bekannte Manipulatoren, beispielsweise Roboter bzw. Greifer, vor Herausforderungen diese exakt zu greifen, zu halten, zu positionieren bzw. handhaben zu können. Mit einer meist zeitaufwendigen Feinpositionierung der Manipulatoren bzw. auch mit einer Fehlhandhabung solcher Mikrobauteile ist zu rechnen, was sowohl zu langen Zykluszeiten als auch Beschädigungen am Mikrobauteil führen kann.

Die Erfindung hat sich daher ausgehend vom eingangs geschilderten Stand der Technik die Aufgabe gestellt, ein Verfahren zur Herstellung eines Halbzeugs mit mindestens einem Mikrobauteil derart zu verändern, dass trotz kleinster Abmessungen am gespritzten Halbzeug risikofrei kurze Zykluszeiten erreicht werden können.

Die Erfindung löst die gestellte Aufgabe hinsichtlich des Verfahrens dadurch, dass das für den Formraum des Spritzgießwerkzeugs vorgesehene verlorene Teil als makroskopischer Objektträger für das Mikrobauteil zur Handhabung des Halbzeugs ausgebildet wird und der Formraum mit diesem verlorenen Teil versehen wird.

Wird das für den Formraum des Spritzgießwerkzeugs vorgesehene verlorene Teil als makroskopischer Objektträger für das Mikrobauteil ausgebildet und der Formraum mit diesem verlorenen Teil versehen, kann in erster Linie die Handhabung des Mikrobauteils erleichtert werden, weil ein eventueller Manipulator nicht am Mikrobauteil, sondern am demgegenüber größeren und/oder schwereren Objektträger angreifen kann. Eine zeitaufwendige Feinpositionierung des Manipulators kann damit vermieden werden, was die Zykluszeit des erfindungsgemäßen Verfahrens deutlich vermindern kann. Zudem kann damit die Gefahr einer falschen Handhabung des Halbzeugs durch den Manipulator reduziert werden, was die Reproduzierbarkeit des erfindungsgemäßen Verfahrens weiter erhöhen kann. In weiterer Linie kann diese Handhabung des Halbzeugs über den verlorenen Teil nachteilige Handhabungseffekte vom Mikrobauteil fernhalten, zumal es in der Natur des verlorenen Teils liegt, vom Mikrobauteil vollständig getrennt zu werden. Kratzer bzw. andere Materialbeschädigungen am verlorenen Teil können somit die Reproduzierbarkeit des Verfahrens nicht beeinträchtigen, was der Wirtschaftlichkeit des Verfahrens zugutekommen kann. Das erfindungsgemäße Verfahren ist daher nicht nur schnell, sondern auch höchst reproduzierbar durchzuführen, was für eine Kostensenkung genützt werden kann. Vorzugsweise kann hierzu der verlorene Teil durch ein Spritzgießverfahren aus einem Kunststoffmaterial, insbesondere aus einem Thermoplast, hergestellt sein, um die geforderten makroskopischen Eigenschaften zum Objektträger zu erreichen.

Die Handhabung des Halbzeugs kann erleichtert werden, wenn am verlorenen Teil mindestens eine Handhabungsfläche an der Außenseite des Halbzeugs ausgebildet wird, die vom Mikrobauteil freigestellt ist. Dies kann zudem das sichere und schnelle Greifen des Halbzeugs vom Manipulator erhöhen und damit das Verfahren weiter erleichtern.

Die Reproduzierbarkeit des Verfahrens kann weiter erhöht werden, wenn zur Ausbildung der Verbindung zwischen Mikrobauteil und verlorenem Teil beim Mehrkomponenten-Spritzgießverfahren durch mindestens eine Öffnung am verlorenen Teil der zweite Werkstoff gespritzt wird. Über diese Öffnung im verlorenen Teil kann nämlich das Mikrobauteil an dessen Halsabschnitt zuverlässig gehalten werden, was selbst eine beschädigungsfreie Handhabung von vergleichsweise schlanken Mikrobauteilen sicherstellen kann.

Das Halbzeug kann für das Entfernen des verlorenen Teils dahin gehend vorbereitet werden, in dem im verlorenen Teil eine Sollbruchstelle ausgebildet wird. Vorzugsweise geschieht diese Ausbildung vor dem Einspritzen des zweiten Werkstoffs auf einer Elastomerbasis in den Formraum des Spritzgusswerkzeugs. Zudem kann damit das Zerteilen des verlorenen Teils und in weiterer Folge das Lösen der formschlüssigen Verbindung in vorbestimmten Bahnen verlaufen, um Beschädigungen am Mikrobauteil zu vermeiden.

Wird zudem diese Sollbruchstelle der formschlüssigen Verbindung zulaufend ausgebildet, kann beim Entfernen des verlorenen Teils die Gefahr einer Beschädigung am Mikrobauteil weiter vermindert werden. Vorzugsweise dann, wenn die Sollbruchstelle der Öffnung zulaufend ausgebildet wird. Zudem kann damit ein zuverlässiges Trennen der formschlüssigen Verbindung zwischen der Öffnung des verlorenen Teils und dem Mikrobauteil gewährleistet werden, wobei eine derart verlaufende Sollbruchstelle auch keine Beeinträchtigung der Handhabung des Halbzeugs erwarten lässt. Dies kann verbessert werden, wenn die Sollbruchstelle vor der Öffnung endet.

Kürzere Zykluszeiten im Verfahren können sich weiter ergeben, wenn der verlorene Teil durch ein Spritzgießverfahren aus einem Kunststoffmaterial hergestellt wird. Insbesondere kann hierbei auch eine Sollbruchstelle am verlorenen Teil hergestellt werden. Weitere Optimierungen können sich ergeben, wenn der verlorene Teil in einer Kavität des Spritzgießwerkzeugs für das Mehrkomponenten-Spritzgießverfahren erzeugt wird und über eine Indexplatte in den Formraum für das Mehrkomponenten-Spritzgießverfahren eingebracht, beispielsweise eingedreht, wird. Zu diesem Indexverfahren andere Verfahren sind denkbar, beispielsweise die Transfertechnik mit parallel zueinander angeordneten Maschinen.

Die feste formschlüssige Verbindung zwischen verlorenem Teil und Mikrobauteil kann reproduzierbar ausgebildet werden, wenn beim Mehrkomponenten-Spritzgießverfahren das verlorene Teil mindestens einen Hinterschnitt am Mikrobauteil ausbildet. Dies kann weiter verbessert werden, wenn damit ein verdeckter Hinterschnitt am Mikrobauteil ausgebildet wird. Solche ein Hinterschnitt kann beispielsweise durch eine Auskragung am verlorenen Teil geschaffen werden. Außerdem stellt dieser Hinterschnitt kein Hindernis im Verfahren dar, auch dann nicht, wenn das verlorene Teil vom Mikrobauteil getrennt wird. Zumal in diesem Fall der Hinterschnitt dann am Mikrobauteil zugänglich ist und die Handhabung erleichtern kann. Diese so entstandene Montageausnehmung kann nämlich auf ein eventuelles Montagewerkzeuge abgestimmt werden.

Im Allgemeinen wird erwähnt, dass auf Grundlage der erleichterten Handhabbarkeit des Halbzeugs das Verfahren auch dazu verwendet werden kann, das Halbzeug mit einem medikamentösen Wirkstoff zu verbinden. Dies kann beispielsweise durch Besprühen, Rollbeschichtung oder dergleichen erfolgen. Damit kann auch sichergestellt werden, dass das Mikrobauteil diesen Wirkstoff trägt, auch wenn der verlorene Teil vom Mikrobauteil entfernt wird. Zudem ist vorstellbar, der Elastomerbasis des Mikrobauteils diesen Wirkstoff, zum Beispiel mit einer antibakteriellen Wirkung etc., beizumengen.

Besonders auszeichnen kann sich das vorstehend beschriebene Verfahren, in dem dieses bei der Herstellung eines Mikrobauteils Anwendung findet. Dabei wird, um das Mikrobauteil vom Halbzeug freizugeben, der verlorene Teil vom Halbzeug entfernt. Insbesondere ein Trennen des verlorenen Teils vom Halbzeug kann ein schnelles Entfernen des verlorenen Teils vom Mikrobauteil ermöglichen. Die Reproduzierbarkeit dieses Trennschritts kann weiter erhöht werden, wenn der verlorene Teil entlang seiner Sollbruchstelle am verlorenen Teil abgebrochen wird, um das Mikrobauteil vom Halbzeug freizugeben.

Die Erfindung hat sich zudem ausgehend vom eingangs geschilderten Stand der Technik die Aufgabe gestellt, ein Halbzeug mit einem verlorenen Teil und einem Mikrobauteil zu schaffen, das trotz kleinster Abmessungen am Mikrobauteil von einem Manipulator einfach und sicher gehandhabt werden kann. Zudem soll ein standfestes Halbzeug ermöglicht werden.

Die Erfindung löst die gestellte Aufgabe hinsichtlich des Halbzeugs dadurch, dass das verlorene Teil als makroskopischer Objektträger für das Mikrobauteil zur Handhabung des Halbzeugs ausgebildet ist.

Ist verlorene Teil als makroskopischer Objektträger für das Mikrobauteil ausgebildet, können mechanische Belastungen vom gegenüber dem Mikrobauteil größeren und/oder massereicheren Objektträger abgetragen werden. Die Standfestigkeit des Halbzeugs kann damit erheblich erhöht werden. Außerdem kann damit das Mikrobauteil von Belastungen durch einen Manipulator freigestellt werden, weil der Objektträger zur Handhabung des Halbzeugs dienen kann, was selbst ein filigranes Mikrobauteil gegenüber Beschädigungen schützen und damit das erfindungsgemäße Halbzeug erheblich verbessern kann.

Bildet das verlorene Teil mindestens eine Handhabungsfläche an der Außenseite des Halbzeugs aus, die vom Mikrobauteil freigestellt ist, können selbst Beschädigungen im Bereich der Handhabungsfläche zu keiner Beeinträchtigung des Mikrobauteils führen. Zumal das verlorene Teil zum Entfernen vom Mikrobauteil vorgesehen ist und damit keinen Bestandteil des Mikrobauteils darstellt. Hinzu kommt, dass die Handhabung des Halbzeugs durch die in Relation zum Mikrobauteil flächengrößere Handhabungsfläche einfacher und sicher werden kann.

Im Allgemeinen wird erwähnt, dass das Entfernen des verlorenen Teils durch Zerstören der unlösbaren formschlüssigen Verbindung zwischen Halbzeug und Mikrobauteil erfolgen kann.

Bildet das verlorene Teil mindestens eine Positionierhilfe an der Außenseite des Halbzeugs aus, die vom Mikrobauteil freigestellt ist, kann diese die Handhabung des Halbzeugs weiter erleichtern. Solch eine Positionierhilfe kann beispielsweise von einer Kerbe oder Ausnehmung am verlorenen Teil gebildet werden.

Weist das verlorene Teil eine Öffnung auf, durch die das Mikrobauteil zur Ausbildung der Verbindung ragt, können selbst schlanke Mikrobauteile standfest mit dem verlorenen Teil verbunden bzw. am Halbzeug befestigt werden. Vereinfachte Handhabungsverhältnisse zum Halbzeug können sich ergeben, wenn der verlorene Teil plattenförmig ausgebildet ist.

Das Entfernen des verlorenen Teils kann weiter vereinfacht werden, wenn der verlorene Teil eine Sollbruchstelle aufweist, über die die formschlüssige Verbindung zwischen Mikrobauteil und verlorenem Teil zerstört werden kann. Dieses Zerstören kann beschädigungsfrei für das Mikrobauteil enden, wenn die Sollbruchstelle der formschlüssigen Verbindung, insbesondere der Öffnung, zuläuft und insbesondere davor endet.

Besonders handhabungsfreundlich kann das Halbzeug dadurch werden, in dem der verlorene Teil plattenförmig ausgebildet ist. Vorzugsweise kann Thermoplast als Werkstoff für den verlorenen Teil den spritzgusstechnischen Anforderungen genügen und auch eine ausreichende Festigkeit zum Halten von Mikrobauteilen mit einer Elastomerbasis gewährleisten.

Weist das verlorene Teil mindestens eine Auskragung auf, die einen, insbesondere verdeckten, Hinterschnitt am Mikrobauteil ausbildet, können selbst schlanke Mikrobauteile standfest am verlorenen Teil gehalten werden bzw. am makroskopischen Objektträger befestigt werden.

In den Figuren ist der Erfindungsgegenstand beispielsweise dargestellt. Es zeigen
- Fig. 1: eine Draufsicht auf ein Halbzeug mit einem Mikrobauteil,
- Fig. 2: eine Schnittansicht nach II-II der Fig. 1 und
- Fig. 3: eine Unteransicht der Fig. 1.

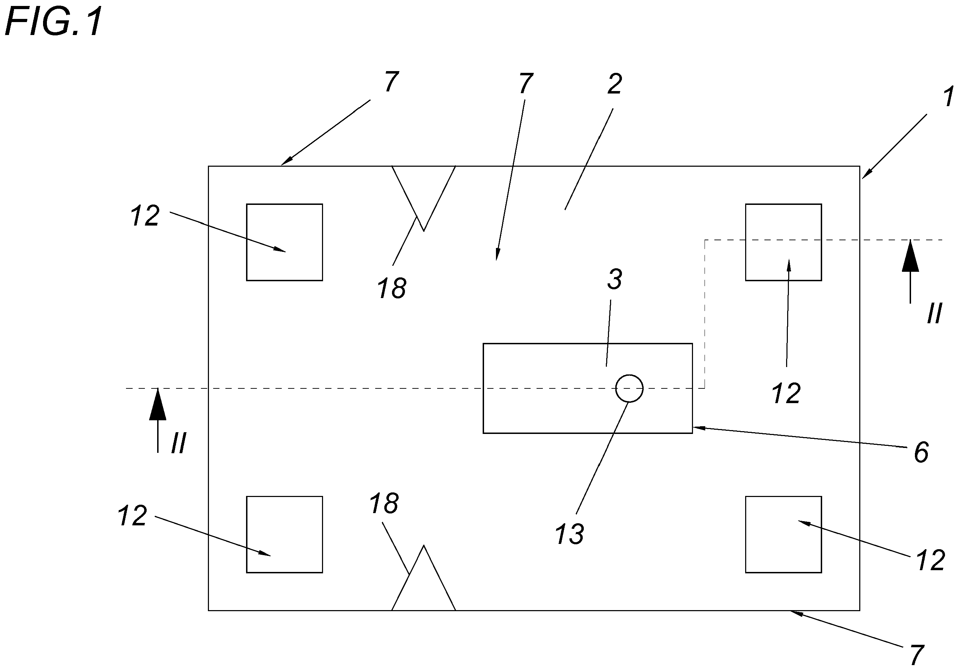

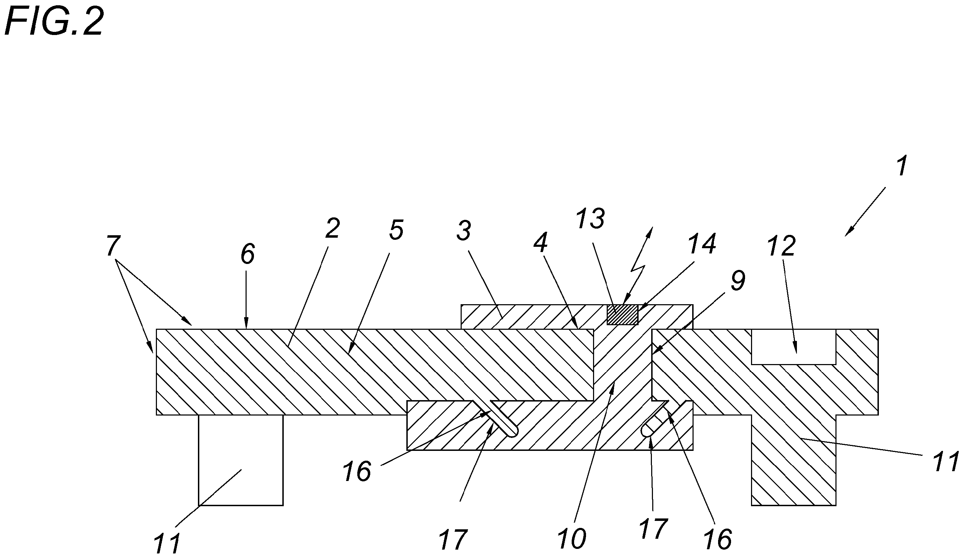

Gemäß den Figuren 1 bis 3 wird beispielsweise das erfindungsgemäße Halbzeug 1 aus einem verlorenen Teil 2 und aus einem Mikrobauteil 3 gezeigt. Der verlorene Teil 2 und das Mikrobauteil 3 weisen unterschiedliche Werkstoffe auf - so besteht das verlorene Teil 2 aus einem Thermoplast und das Mikrobauteil 3 aus Silikon. Andere Werkstoffe sind vorstellbar. Der verlorene Teil 2 und das Mikrobauteil 3 sind über eine formschlüssige Verbindung 4 miteinander fest verbunden. Diese Verbindung 4 ist insbesondere in Fig. 2 zu erkennen. Vorzugsweise ist diese Verbindung 4 auf chemischer Wechselwirkung beruhend stoffschlussfrei. Die Verbindung 4 wird durch Verwendung eines bekannten, nicht näher dargestellten Mehrkomponenten-Spritzgießverfahrens geschaffen, indem in einem Formraum eines Spritzgießwerkzeugs das verlorene Teil 2 vorgesehen und anschließend ein Werkstoff auf einer Elastomerbasis, nämlich beispielsweise Silikon, eingespritzt wird, um damit das Mikrobauteil 3 zu schaffen. Durch Entfernen, beispielsweise Zerstören, des verlorenen Teils 2 kann diese feste formschlüssige Verbindung 4 aufgehoben und damit das Mikrobauteil 3 vom Halbzeug 1 getrennt werden.

Im Gegensatz zu bekannten Halbzeugen mit Mikrobauteilen dient das erfindungsgemäße verlorene Teil 2 nicht nur zur Ausbildung von Konturen am Mikrobauteil 3, sondern übernimmt auch die Funktion eines makroskopischen Objektträgers 5 für das Mikrobauteil 3. Durch die Wahl eines makroskopischen Objektträgers 5 ist auch eine automatisierte Handhabung des Mikrobauteils 3 erleichtert - zudem geht insbesondere auch dessen Beschädigungsgefahr aufgrund nicht näher dargestellter Manipulatoren zurück. Letzteres im Speziellen auch dadurch, dass der verlorene Teil 2 eine vom Mikrobauteil 3 freigestellte Handhabungsfläche 7 für den Manipulator an der Außenseite 6 des Halbzeugs 1 ausbildet. Ein Manipulator kann nämlich zur Handhabung des Halbzeugs 1 Berührungsflächen am Mikrobauteil 3 vermeiden - über das verlorene Teil 2 kann das getragene Mikrobauteil 3 bzw. das Halbzeug 1 Manipulieraufgaben, Positionieraufgaben und/oder Messaufgaben zugeführt werden. Unter anderem hält der Manipulator beim Positionieren des Mikrobauteils 3 dieses belastungsfrei.

Diese Handhabungsfläche 7 ist, wie in den Figuren 1 bis 3 zu erkennen, an der Außenseite 6 des Halbzeugs 1 in der Fläche erheblich größer als dies in Relation dazu das Mikrobauteil 3 ist. Solch eine Handhabungsfläche 7 kann auf verfahrenstechnisch einfache Weise dadurch hergestellt werden, indem beim Mehrkomponenten-Spritzgießverfahren das verlorene Teil 2 vom zweiten Werkstoff dementsprechend freigestellt bleibt. Dies kann beispielsweise durch die Formgebung des Formraums des Spritzgusswerkzeugs und/oder auch beim Auswerfen des Mikrobauteils 3 aus dem Spritzgusswerkzeug durch Abriss, durch Laserschneiden oder einem anderen Trennverfahren erfolgen. Im Allgemeinen wird erwähnt, dass sich diese Handhabungsfläche 7 an beliebigen Seiten des verlorenen Teils 2 ausbilden kann, die vom Mikrobauteil 3 außen am Halbzeug 1 freigestellt bleibt. Diese Handhabungsfläche 7 kann beispielsweise von Greifern, Saughalter etc. genützt werden, um das Halbzeug 1 für weitere Schritte zu manipulieren.

Das erfindungsgemäße Mehrkomponenten-Spritzgießverfahrens zur Herstellung dieses Mikrobauteils kann auch als Mehrkomponenten-Mikrospritzgießverfahren verstanden werden.
Hierzu wird im Allgemeinen festgehalten, dass ein Spritzgießen von Mikrobauteilen bzw. Mikrospritzgießen sich prinzipiell anhand der Vorgänge bei der Herstellung von Makrobauteilen erklären lässt. Die Unterschiede liegen vor allem im Gewicht der Bauteile. So wird im Allgemeinen erwähnt, dass sich das Gewicht der Mikrobauteile im Bereich weniger mg bzw. vorzugsweise unter 10 mg bewegen kann, was dementsprechend zu Dimensionen beginnend im µm-Bereich bis hin zu 0,1 µm führen kann. Im Gegensatz dazu liegt das Bauteilgewicht und damit auch die Größe von Makrobauteilen meist deutlich über dem µm-Bereich.

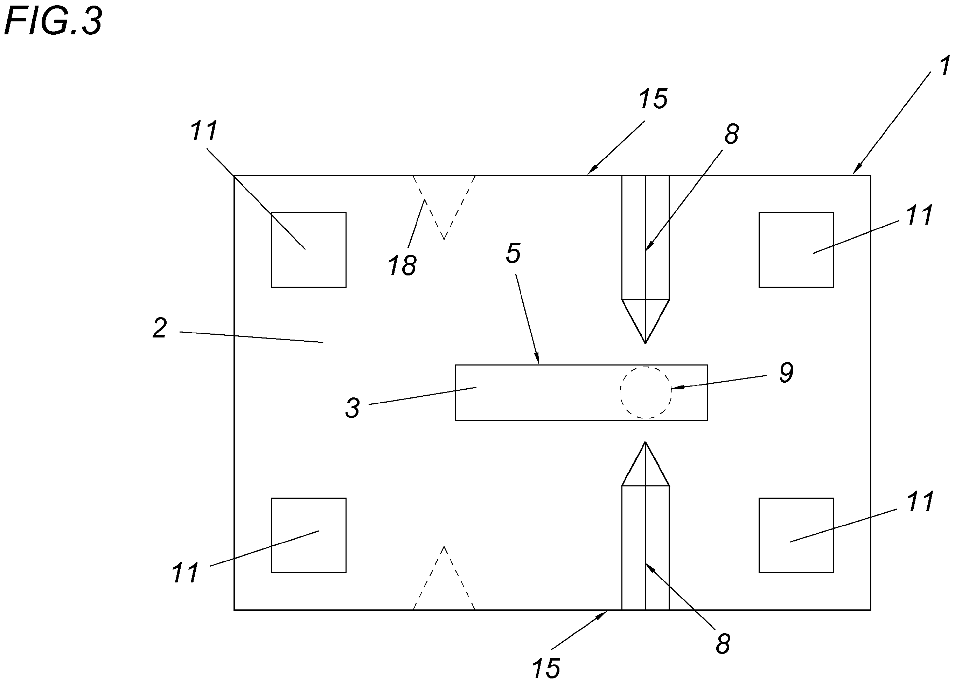

Das Entfernen des verlorenen Teils 2 bzw. des Objektträgers ist erheblich einfacher, wenn der verlorene Teil 2 eine nach Fig. 3 dargestellte Sollbruchstelle 8 aufweist. Diese Sollbruchstelle 8 zeichnet sich zudem dadurch aus, dass sie von den gegenüberliegenden Stirnseiten 15 des verlorenen Teils 2 bzw. des Halbzeugs 1 auf eine Öffnung 9 im verlorenen Teil 2 zuläuft, welche Öffnung 9 mit dem durchragenden Mikrobauteil 3 bzw. dessen Hals 10 zur formschlüssigen Verbindung 4 beiträgt. Bricht das verlorene Teil 2 entlang dieser Sollbruchstelle 8, wird damit die formschlüssige Verbindung 4 zwischen verlorenem Teil 2 und Mikrobauteil 3 zerstört und das Mikrobauteil 3 beschädigungsfrei freigegeben. Wie zudem der Fig. 3 zu entnehmen ist, endet die Sollbruchstelle 8 im verlorenen Teil 2 vor der Öffnung spitz zulaufend, um im Bereich des umschlossenen Halses 10 des Mikrobauteils 3 eine Schwächung der Festigkeit des Halbzeugs 1 zu vermeiden, dennoch aber eine sichere Bruchlinie zu schaffen. Es ist außerdem vorstellbar, dass das Mikrobauteil 3 aus dem verlorenen Teil 2 bzw. dem Objektträger herausgedrückt wird, was bei solchen Silikonbauteilen durchaus möglich ist.

Wie der Fig. 2 zu entnehmen, ist das Halbzeug 1 flach und im weiteren Sinne plattenförmig ausgeführt. Am Halbzeug 1 sind Stellfüße 11 angespritzt, um das Halbzeug 1 beschädigungsfrei in Bezug auf das Mikrobauteil 3 abstellen zu können. Fußausnehmungen 12 an der Oberseite des Halbzeugs erleichtern die Stapelbarkeit von Halbzeugen 1.

Durch die reproduzierbare Handhabung des Halbzeugs 1 eignet sich das Mikrobauteil 3 besonders zur Anwendung in der Elektrotechnik, indem das Halbzeug mit einem passiven RFID-Transponder 13 versehen wird. Gemäß Fig. 2 ist dieser RFID-Transponder 13 in einer Ausnehmung 14 des Mikrobauteils 3 vorgesehen. Denkbar ist auch, einen medikamentösen Wirkstoff 13 in dieser Ausnehmung vorzusehen. All das wird reproduzierbar möglich, in dem die Handhabungsflächen 7 am verlorenen Teil 2 eine exakte Positionierung des Mikrobauteils 3 von einem Manipulator möglich machen.

Zudem kann das Mikrobauteil 3 einerseits vom verlorenen Teil 2 besonders sicher und andererseits von einem Handwerkzeug standfest gehalten werden, wenn am Mikrobauteil 3 mehrere Montageausnehmungen vorgesehen sind. Einer dieser Montageausnehmungen wird verfahrenstechnisch einfach am Mikrobauteil 3 ermöglicht, in dem beim Mehrkomponenten-Spritzgießverfahren eine Auskragung 16 am verlorenen Teil 2 einen verdeckten Hinterschnitt 17 ausformt - verdeckt dadurch, dass erst nach einem Entfernen eines Teils (beispielsweise die nach Fig. 2 dargestellte rechte Hälfte des verlorenen Teils 2) diese Montageausnehmung zugänglich wird bzw. damit freigelegt werden kann. Damit wird es auch möglich, nach einem Teilentfernen des verloren Teils 2, das Mikrobauteil 3 bereits zu halten und zu greifen, bevor das verlorene Teil 2 vollständig entfernt wird. Die Handhabung des Mikrobauteils 3 ist daher benutzerfreundlich. Wie in der Fig. 2 strichliert dargestellt, ist es zudem vorstellbar, dass am verlorenen Teil 2 zwei oder mehrere Auskragungen 16 vorgesehen sind, um damit beispielsweise den Zusammenhalt des Halbzeugs 1 zu verbessern.

Wie insbesondere der Fig. 1 weiter zu entnehmen, sind auf der Oberseite des Halbzeugs 1, nämlich am verlorenen Teil 2 zwei gegenüberliegende nutenförmige Ausnehmungen vorgesehen, die als Positionierhilfe 18 dienen. Damit kann das Halbzeug 1 über in diese Positionierhilfe 18 eingreifbare nicht näher dargestellte Zentriernasen auf einfache Weise für den Manipulator ausgerichtet werden. Die Handhabung des Halbzeugs 1 kann sich dadurch noch weiter erleichtern.

Im Allgemeinen wird weiter erwähnt, dass eine Elastomerbasis auf Basis von NBR (Nitrilkautschuk), HNBR (Hydrierter Nitrilkautschuk), FPM (Fluorelastomer), EPDM (Ethylen-Propylen Kautschuk mit dritter Komponente), ECO (Epichlorhydrin-Kautschuk), TPE (Thermoplastische Elastomere) mit oder ohne Trennmittel, HTV-Silikon (High temperature vulcanised Silikonkautschuk) oder auch Silikon im Allgemeinen aufgebaut sein kann.

## Patentansprüche

1. Verfahren zur Herstellung eines mindestens ein Mikrobauteil (3) aufweisenden Halbzeugs (1) unter Verwendung eines Mehrkomponenten-Spritzgießverfahrens, bei dem wenigstens ein Formraum eines Spritzgießwerkzeugs mit mindestens einem verlorenen Teil (2) aus einem ersten Werkstoff, insbesondere aus einem spritzgegossenen Kunststoffmaterial, versehen wird und in einem weiteren Schritt zur Erzeugung des Mikrobauteils (3) ein zum ersten Werkstoff unterschiedlicher zweiter Werkstoff auf einer Elastomerbasis, insbesondere Silikonbasis, eingespritzt wird, wodurch sich zwischen Mikrobauteil (3) und verlorenem Teil (2) eine feste und formschlüssige Verbindung (4) ausbildet, **dadurch gekennzeichnet, dass** das verlorene Teil (2) als makroskopischer Objektträger (5) für das Mikrobauteil (3) zur Handhabung des Halbzeugs (1) ausgebildet wird und der Formraum mit diesem verlorenen Teil (2) versehen wird.

2. Verfahren nach Anspruch 1, **dadurch gekennzeichnet, dass** am verlorenen Teil (2) mindestens eine Handhabungsfläche (7) an der Außenseite (6) des Halbzeugs (1) ausgebildet wird, die vom Mikrobauteil (3) freigestellt ist.

3. Verfahren nach Anspruch 1 oder 2, **dadurch gekennzeichnet, dass** zur Ausbildung der Verbindung (5) zwischen Mikrobauteil (3) und verlorenem Teil (2) beim Mehrkomponenten-Spritzgießverfahren durch mindestens eine Öffnung (9) am verlorenen Teil (2) der zweite Werkstoff gespritzt wird.

4. Verfahren nach Anspruch 1, 2 oder 3, **dadurch gekennzeichnet, dass** im verlorenen Teil (2) eine Sollbruchstelle (8) ausgebildet wird.

5. Verfahren nach Anspruch 4, **dadurch gekennzeichnet, dass** die Sollbruchstelle (8) der formschlüssigen Verbindung (4), insbesondere Öffnung (9), zulaufend und insbesondere davor endend ausgebildet wird.

6. Verfahren nach einem der Ansprüche 1 bis 5, **dadurch gekennzeichnet, dass** beim Mehrkomponenten-Spritzgießverfahren das verlorene Teil (2) mindestens einen, insbesondere verdeckten, Hinterschnitt (17) am Mikrobauteil (3) ausbildet.

7. Herstellungsverfahren für ein Mikrobauteil (3), bei dem ein Halbzeug (1) nach einem der Ansprüche 1 bis 6 hergestellt und der verlorene Teil (2) vom Halbzeug (1) entfernt wird.

8. Herstellungsverfahren nach Anspruch 7, **dadurch gekennzeichnet, dass** der verlorene Teil (2) vom Halbzeug (1) getrennt, insbesondere über dessen Sollbruchstelle (8) abgebrochen wird.

9. Halbzeug mit einem verlorenen Teil (2), mit mindestens einem Mikrobauteil (3) aus einem zum Werkstoff des verlorenen Teils (2) unterschiedlichen Werkstoff, der eine Elastomerbasis, insbesondere Silikonbasis, aufweist, und mit einer festen und formschlüssigen Verbindung (4), die zwischen Mikrobauteil (3) und verlorenem Teil (2) vorgesehenen ist, **dadurch gekennzeichnet, dass** das verlorene Teil (2) als makroskopischer Objektträger (5) für das Mikrobauteil (3) zur Handhabung des Halbzeugs (1) ausgebildet ist.

10. Halbzeug nach Anspruch 9, **dadurch gekennzeichnet, dass** das verlorene Teil (2) mindestens eine Handhabungsfläche (7) an der Außenseite (6) des Halbzeugs (1) ausbildet, die vom Mikrobauteil (3) freigestellt ist.

11. Halbzeug nach Anspruch 9 oder 10, **dadurch gekennzeichnet, dass** das verlorene Teil (2) mindestens eine Positionierhilfe (18) an der Außenseite (6) des Halbzeugs (1) ausbildet, die vom Mikrobauteil (3) freigestellt ist.

12. Halbzeug nach Anspruch 9, 10 oder 11, **dadurch gekennzeichnet, dass** das verlorene Teil (2) eine Öffnung (9) aufweist, durch die das Mikrobauteil (3) zur Ausbildung der Verbindung (4) ragt.

13. Halbzeug nach einem der Ansprüche 9 bis 12, **dadurch gekennzeichnet, dass** das verlorene Teil (2) eine Sollbruchstelle (8) zum Zerstören der Verbindung zwischen Mikrobauteil (3) und verlorenem Teil (2) aufweist, wobei insbesondere die Sollbruchstelle (8) der formschlüssigen Verbindung (4) zuläuft, vorzugsweise der Öffnung (9) zuläuft und davor endet.

14. Halbzeug nach einem der Ansprüche 9 bis 13, **dadurch gekennzeichnet, dass** das, insbesondere aus einem Thermoplast bestehende, verlorene Teil (2) plattenförmig ausgebildet ist.

15. Halbzeug nach einem der Ansprüche 9 bis 14, **dadurch gekennzeichnet, dass** das verlorene Teil (2) mindestens eine Auskragung (16) aufweist, die einen, insbesondere verdeckten, Hinterschnitt (17) am Mikrobauteil (3) ausbildet.
